Europäisches Patentamt

European Patent Office

Office européen des brevets

(11) Publication number : **0 117 180 B1**

# EUROPEAN PATENT SPECIFICATION

(45) Date of publication of patent specification :
**30.11.94 Bulletin 94/48**

(51) Int. Cl.$^5$ : **H03K 17/04, H03K 17/14, H03K 17/60**

(21) Application number : **84400195.8**

(22) Date of filing : **30.01.84**

(54) **Differential switching circuit.**

(30) Priority : **31.01.83 JP 14058/83**

(43) Date of publication of application :
**29.08.84 Bulletin 84/35**

(45) Publication of the grant of the patent :
**30.11.94 Bulletin 94/48**

(84) Designated Contracting States :
**DE FR GB**

(56) References cited :
**IBM TECHNICAL DISCLOSURE BULLETIN,
vol. 19, no. 7, December 1976, page 2562, New
York, US; D. AZZIS: "Fast and accurate
switch"
PATENTS ABSTRACTS OF JAPAN, vol. 5, no.
66 (E-55)[738], 2nd May 1981; & JP-A-56 16 324
(PIONEER K.K.) 17-02-1981
IBM TECHNICAL DISCLOSURE BULLETIN,
vol. 23, no. 3, August 1980, pages 1072-1073,
New York, US; J.L. PETER: "Current switch
circuit with variable current source"**

(73) Proprietor : **FUJITSU LIMITED
1015, Kamikodanaka
Nakahara-ku
Kawasaki-shi Kanagawa 211 (JP)**

(72) Inventor : **Yasutake, Nobuyuki
Yoshimura Haitsu 201
4-1-7, Utsukushigaoka
Midori-ku Yokohama-shi Kanagawa 227 (JP)**
Inventor : **Tsuda, Toshitaka
Minaminomachi 3-403
515-1, Shinano-cho
Totsuka-ku Yokohama-shi Kanagawa 244 (JP)**

(74) Representative : **Descourtieux, Philippe et al
Cabinet Beau de Loménie
158, rue de l'Université
F-75340 Paris Cédex 07 (FR)**

EP 0 117 180 B1

## Description

DIFFERENTIAL SWITCHING CIRCUIT

BACKGROUND OF THE INVENTION

1. Field of the Invention

The present invention relates to a differential switching circuit, more particularly a differential switching circuit consisting of a pair of transistors having commonly coupled emitters used for a digital to-analog (D/A) converter.

2. Description of the Prior Art

Prior art differential switching circuits, composed of a pair of transistors having commonly coupled emitters and a fixed current source connected to the emitters, suffer from the defect of unstable output potential due to temperature-based variation of the current amplification. Additionally, there is the problem, in D/A converters etc., using a plurality of such differential switching circuits, of variation of current amplification factors hFE due to manufacturing differences of elements constituting the circuits.

A conventional means to overcome the fluctuations, in a circuit used for a D/A converter with a resolution above 12 bits has been to provide an addtional transistor for each of the pair of transistors in a so-called "Darlington Connection."

The Darlington connections, however, reduce the operating speed of the circuit. To raise the speed, a resistor has been inserted between each two transistors in a Darlington connection. Thus, however, conversely results in current fluctuation through the resistor.

In summary, the prior art differential switching circuit has had the defect of reduced operating speed in the case of stable current amplification, and unstable current amplification in the case of increased operating speed.

SUMMARY OF THE INVENTION

In another differential switching circuit disclosed in IBM Technical Disclosure Bulletin, Vol. 19, N° 7, December 1976, page 2562, only one side is Darlington connected. While the input signal is applied to the other side, the Darlington side is supplied with a constant voltage. Clamping diodes are provided in order to speed up the switching operation. However, when the temperature varies, the value of the current flowing in the clamping diodes is largely varied and, hence, the output level also.

SUMMARY OF THE INVENTION

An object of the present invention is to provide a differential switching circuit with both stable current amplification and increased operating speed, whose output is not affected by a change in the temperature, without decrease of its switching speed.

The above-mentioned object can be achieved by a differential switching circuit comprising a first current switching circuit having a first input terminal to which a first input signal is applied, and a first threshold voltage, a second current switching circuit having a second threshold voltage different from said first threshold voltage, and a constant current source commonly connected to said first and second circuits. The second current switching circuit is constructed in such a manner that it comprises a plurality of transistors connected as a Darlington connection in which all of the current flowing from the emitter of a previous stage transistor is supplied to the base of a following stage transistor, and has a second input terminal to which a second input signal complementary to said first input signal is applied.

BRIEF DESCRIPTION OF THE DRAWINGS

Further features and advantages of the present invention will be apparent from the ensuring description with reference to the accompanying drawings, wherein:

Figs. 1 and 2a and 2b are circuit diagrams of conventional differential switching circuits;

Fig. 3a is a circuit diagram of an embodiment of the present invention;

Fig. 3b and 3c are wave forms of the signals applied to the circuit of Fig. 3a;

Figs. 4a to 4d are explanatory views of the circuit diagram in Fig. 3a; and

Fig. 5 is a circuit diagram of another embodiment of the present invention.

DESCRIPTION OF THE PREFERRED EMBODIMENTS

Before describing the preferred embodiments, an explanation of some prior art circuits will be given for reference.

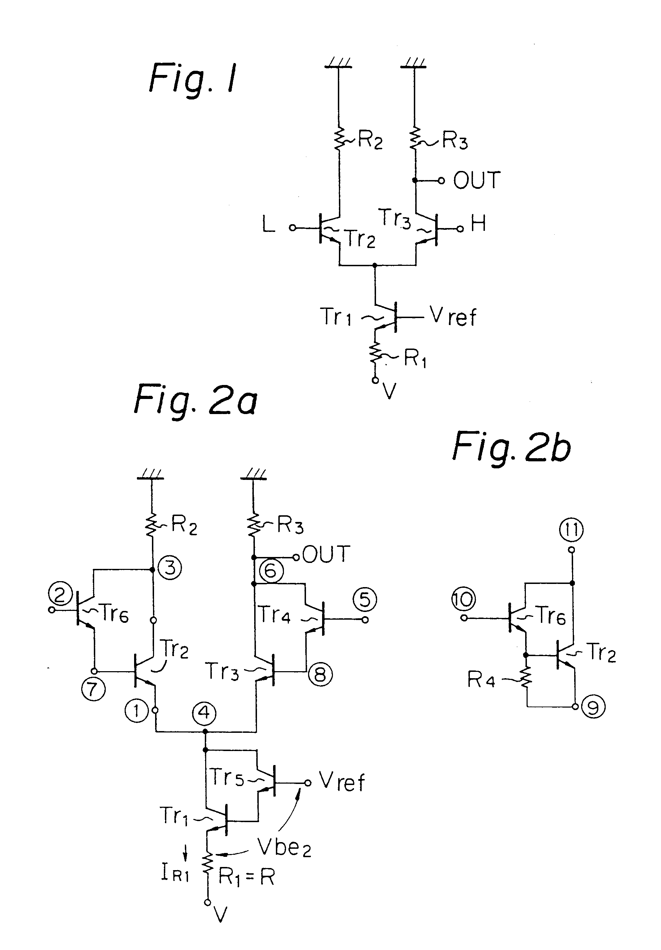

Figure 1 is a circuit diagram of one conventional circuit. This circuit consists of a pair of transistors $T_{r2}$ and $T_{r3}$ having commonly connected emitters. Resistors $R_2$ and $R_3$ are connected to the collectors of the transistors $T_{r2}$ and $T_{r3}$ respectively. A constant current source is connected to the common emitter, which source comprises a transistor $T_{r1}$ and a resistor $R_1$ connected to a voltage source V. A constant voltage $V_{ref}$ is applied to the base of the transistor $T_{r1}$.

When the base potential of the transistor $T_{r3}$ is higher than that of the transistor $T_{r2}$, the transistor $T_{r3}$

is on and a current flows through the resistor $R_3$. Therefore, the potential of a output terminal OUT is low. On the contrary, when the base potential of the transistor $T_{r3}$ is lower than that of the transistor $T_{r2}$, current cannot flow through the resistor $R_3$ and thus the potential of the output terminal OUT is high.

The above circuit has the defect that the output potential fluctuates along with temperature-based variation of the current amplification factor hFE. That is, though a constant current is passed through the emitter of the transistor $T_{r3}$ when the transistor $T_{r3}$ is on, the ratio of the currents of the collector and base changes along with the termperature.

To overcome these and other fluctuations, as shown in Fig. 2(a), additional transistors $T_{r4}$, $T_{r6}$, and $T_{r5}$ have been provided for the transistors $T_{r3}$, $T_{r2}$, and $T_{r1}$, respectively, in a Darlington connection. Assuming, the current amplification factor hFE of the transistor $T_{r3}$ and $T_{r4}$ are equal, the current amplification factor hFE of the Darlington connection circuit consisting of the transistors $T_{r3}$ and $T_{r4}$ is $(hFE)^2$. This enables reduction of the influence of fluctuation of the current amplification factor hFE on the current passing through the resistor $R_3$. The same applies to the Darlington connection circuits consisting of the transistors $T_{r2}$ and $T_{r6}$ and the transistors $T_{r1}$ and $T_{r5}$.

The differential switching circuit shown in Fig. 2a, however, has the defect of reduced operating speed as both the left switch comprised of the transistors $T_{r2}$ and $T_{r6}$ and the right switch comprised of the transistors $T_{r3}$ and $T_{r4}$ are Darlington connection circuits. Specifically, the speed is reduced since the potentials at connections ⑦, ④, and ⑧ are not determined immediately upon input of the signal to terminals ② and ⑤.

To overcome this defect, a resistor $R_4$ has been inserted between the emitters of the transistors $T_{r6}$ and $T_{r2}$, as shown in Fig. 2b. This, however, conversely results in fluctuation of the current.

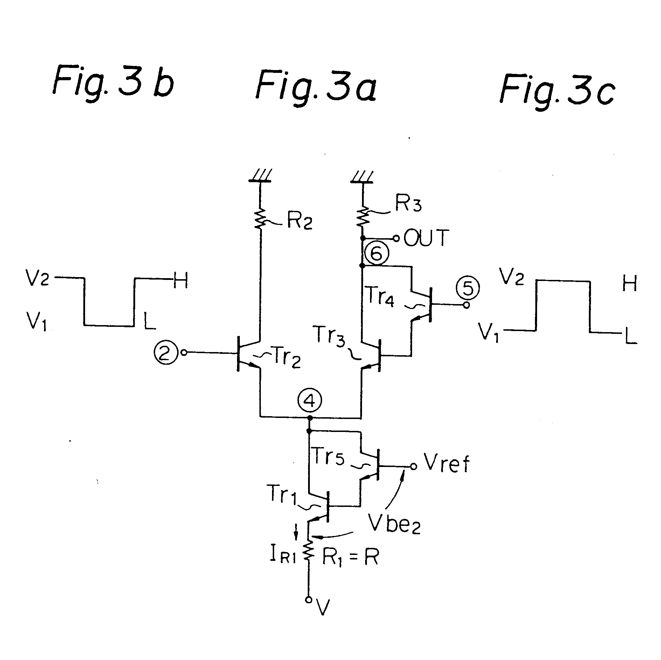

Figure 3a is a diagram of a circuit in accordance with an embodiment of the invention. In the circuit of Fig. 3a, complementary signals as shown in Fig. 3b and 3c are input to the left transistor $T_{r2}$ and the right transistors $T_{r3}$ and $T_{r4}$. The on-and-off switching of these transistors chanqes the potential at a connection ④. When a voltage $V_2$ of "H" input is applied to a terminal ⑤ and a voltage $V_1$ of "L" input is applied to a terminal ②, the transistors $T_{r3}$ and $T_{r4}$ are on, and the transistor $T_{r2}$ is off. In this case, the relationship $V_2 - V_1 > 0.8$ V must be satisfied, the value 0.8 V being the voltage down from the base to the emitter of the single transistor. Therefore, the potential at the connection ④ is about $V_2 - 1.5$ V.

When the voltage $V_1$ of "L" input is applied to the terminal ⑤ and the voltage $V_2$ of "H" input to the terminal ②, the transistor $T_{r2}$ is on and the transistors $T_{r3}$ and $T_{r4}$ are off. In this case, the potential at the connection ④ is $V_2 - 0.8$ V, which is higher than $V_2 - 1.5$ V

in the first case where the transistors $T_{r3}$ and $T_{r4}$ are on. Therefore, as the electrons in the emitter of the transistor $T_{r3}$ are pulled to the emitter of the transistor $T_{r2}$, the transistor $T_{r3}$ is cut off immediately. In this circuit, the flow of electrons between the transistors $T_{r2}$ and $T_{r3}$ contributes to high speed switching.

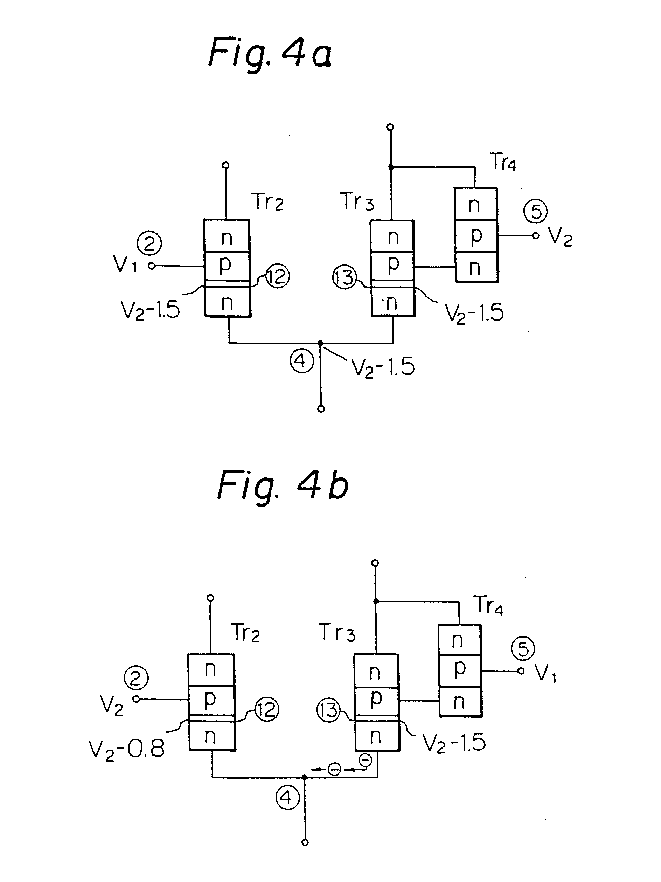

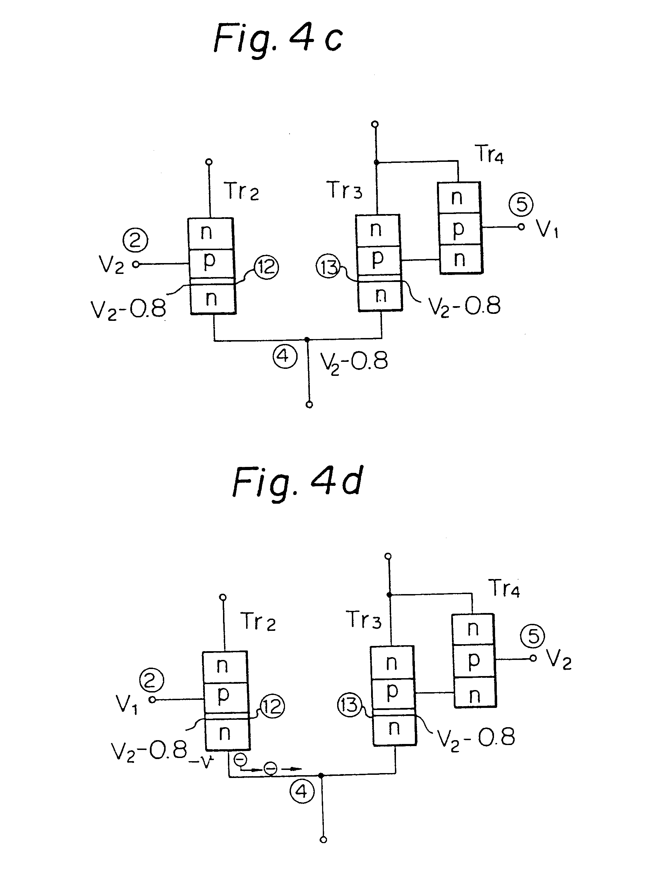

This circuit will be explained further in reference to Figs. 4a to 4d, wherein n-p-n type transistors are depicted.

When the voltage $V_1$ is applied to the base of the transistor $T_{r2}$ and the voltage $V_2$ is applied to the base of the transistor $T_{r4}$ i.e., in the steady state where the transistors $T_{r3}$ and $T_{r4}$ are on and the transistor $T_{r2}$ is off (Fig. 4a), the base-emitter junction of the transistor $T_{r3}$ is biased forward and the potential of the emitter side of the junction face ⑬ is about $V_2 - 1.5$ V. On the other hand, because of the steady state, the base-emitter junction of the transistor $T_{r2}$ is biased reverse. Thus, the potential of the emitter side of the junction face ⑫ and the connection ④ are also $V_2 - 1.5$ V.

When the voltage $V_2$ is applied to the transistor $T_{r2}$ and the voltage $V_1$ is applied to the transistor $T_{r4}$ (Fig. 4b), the base-emitter junction of the transistor $T_{r2}$ is biased forward. The transistor $T_{r2}$ starts to turn on, and the potential of the emitter side of the base-emitter junction of the transistor $T_{r2}$ immediately starts to become $V_2 - 0.8$ V. On the other hand, the voltage $V_1$ applied to the base of the transistor $T_{r4}$ tries to reverse-bias the base-emitter junctions of the transistors $T_{r3}$ and $T_{r4}$. The time necessary for this reverse bias is longer than that for the forward bias between the base and emitter of the transistor $T_{r2}$. Therefore, though the potential of the emitter side face ⑫ of the base-emitter junction of the transistor $T_{r2}$ approaches $V_2 - 0.8$ V, the potential of the face ⑬ of the transistor $T_{r3}$ is near $V_2 - 1.5$ V.

In this transient state, shown in Fig. 4(b), the potential difference between the junction faces ⑫ and ⑬ is about 0.7 V, by which difference the electrons of the majority carrier are moved from the emitter of the transistor $T_{r3}$ to that of the transistor $T_{r2}$. The result is that as the transistor $T_{r2}$ starts to turn on, the emitter of the transistor $T_{r2}$ pulls more electrons from that of the transistor $T_{r3}$. On the contrary, the transistor $T_{r3}$ starts to turn off, and the potential of the emitter of the transistor $T_{r3}$ approaches $V_2 - 0.8$ V as time passes. In this time, $T_{r3}$ and $T_{r4}$ act together and both become more off.

Figure 4c shows a steady state where the transistor $T_{r2}$ is on and the transistors $T_{r3}$ and $T_{r4}$ are off. In

this state, the potentials of the faces (12) and

(13) and the connection ④ are all $V_2$-0.8 V.

When the voltage $V_1$ is applied to the transistor $T_{r2}$ and the voltage $V_2$ is applied to the transistor $T_{r4}$, the transistor $T_{r2}$ starts to turn off and the transistors $T_{r3}$ and $T_{r4}$ start to turn on (Fig. 4d). However, while the potential of the emitter of the transistor $T_{r2}$ is changed immediately, the potential of that of the transistor $T_{r3}$ does not. That is to say, as the voltage $V_1$ is applied to the base of the transistor $T_{r2}$ in the on state, the potential of the junction face (12) starts to fall to $V_2$-0.8V. In this case, the potential of the face

(13) is $V_2$-0.8 V. Therefore, the potential difference V (>0) moves the electrons from the emitter of the transistor $T_{r2}$ to that of the transistor $T_{r3}$.

The result is that the transistor $T_{r2}$ is off and the transistor $T_{r3}$ is on.

As is clear from the above explanation, when the transistors $T_{r3}$ and $T_{r4}$ turn on or off, the transistor $T_{r2}$ supplies or pulls electrons. In other words, the transistor $T_{r2}$ assists the operation of the transistors $T_{r3}$ and $T_{r4}$. As a result, the circuit in accordance with this invention can operate at a high speed even with small complementary signals.

In the circuit of Fig. 3, unlike conventional switching circuits of the left-and-right symmetric type, the potential at the connection ④ changes about 0.7 V depending on whether the transistor $T_{r2}$ or the transistors $T_{r3}$ and $T_{r4}$ are on. The 0.7 V fluctuation in the potential at the connection causes the voltage difference $V_{be2}$ between the base of the transistor $T_{r5}$ and the emitter of the transistor $T_{r1}$ to fluctuate due to the so-called "early effect". As a result, the potential of the emitter side of the transistor $T_{r1}$ also fluctutates. In an actual circuit, the fluctuation is about 2 mV. Therefore, the current $I_{R1}$ through the resistor $R_1$ fluctuates, which adversely affects the stability of the circuit. This current $I_{R1}$ is expressed by the following equation:

$$I_{R1} = \frac{1}{R} \left\{ (V_{ref} - V_{be2}) - V \right\}$$

where; $V_{ref}$ ... Reference potential applied to base of transistor $T_{r5}$

$V_{be2}$ ... Voltage difference between base of transistor $T_{r5}$ and emitter of transistor $T_{r1}$,

V ... Potential of terminal of resistor $R_1$.

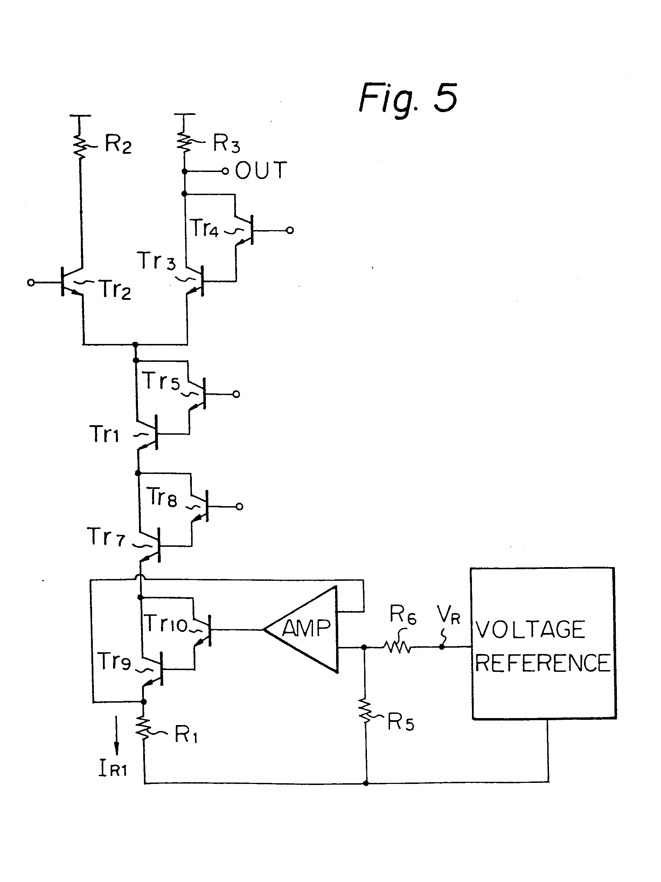

Figure 5 shows another embodiment of the present invention, in which the current fluctuation is prevented. In the circuit, buffer transistors $T_{r5}$, $T_{r1}$ and $T_{r8}$, $T_{r7}$ are inserted in two stages to stabilize the current source. Three or more stages are also possible.

As shown in the figure, a reference voltage is also used to stabilize the voltage of the current source resistor $R_1$ and to stabilize the output current $I_{R1}$. If reference voltage is $V_R$, the current $I_{R1}$ can be expressed by the following equation:

$$I_{R1} = \frac{1}{R_1} \cdot \frac{R_5}{R_5 + R_5} V_R$$

If the base current component in a bipolar type transistor is desired to be deleted, part or all of the transistors in Fig. 5 may be replaced with field effect transistors.

## Claims

1. A differential switching circuit comprising :

a first current switching circuit (Tr$_2$) comprised of a one-transistor stage having a first input terminal (2) to which a first input signal is applied, and a first threshold voltage;

a second current switching circuit (Tr$_3$, Tr$_4$) having a second threshold voltage different from said first threshold voltage, and comprising a first transistor (Tr$_3$) and a second transistor (Tr$_4$) arranged in a Darlington connection, and

a constant current source (Tr$_1$, Tr$_5$, R$_1$) commonly connected to said first and second switching circuits,

characterized in that the second current switching circuit (Tr$_3$, Tr$_4$), is constructed in such a manner that all of a current flowing from the emitter of the second transistor (Tr$_4$) is supplied to the base of the first transistor (Tr$_3$), the base of the second transistor (Tr$_4$) being connected to a second input terminal (5) to which a second input signal complementary to said first input signal is applied, this signal providing an electric potential difference greater than the logic threshold voltage of said second switching circuit, the collectors of the first and second transistors (Tr$_3$, Tr$_4$) being commonly connected to an output terminal,

and that the constant current source comprises a Darlington pair of transistors, i.e. a third transistor (Tr$_5$) the base of which receives a constant voltage (Vref) and a fourth transistor (Tr$_1$) the base of which is connected to the emitter of the third transistor (Tr$_5$), the emitter of the fourth transistor (Tr$_1$) being connected to a voltage source (V) through a resistor (R$_1$) and the collectors of both transistors (Tr$_5$, Tr$_1$) being commonly connected together and to the first and second switching circuits.

2. A differential switching circuit according to claim 1, further comprising a plurality of stages of buffer transistors (Tr$_7$, Tr$_8$, Tr$_9$, Tr$_{10}$) connected in ser-

ies between the current source and the first and second switching circuits, and

a reference voltage source for maintaining a stable voltage (V) at the resistor end of the constant current source.

3. A differential switching circuit according to claim 1, wherein the first and second current switching circuits comprise n-p-n type transistors.

## Patentansprüche

1. Differentialumschaltschaltkreis mit:
einem ersten Stromumschaltschaltkreis ($T_{r2}$), der eine Ein-Transistorstufe, die einen ersten Eingangsanschluß (2) hat, an den ein erstes Eingangssignal angelegt wird, und eine erste Schwellenwertspannung umfaßt,
einem zweiten Stromumschaltschaltkreis ($T_{r3}$, $T_{r4}$), der eine zweite Schwellenwertspannung hat, die verschieden von der ersten Schwellenwertspannung ist und einen ersten Transistor ($T_{r3}$) und einen zweiten Transistor ($T_{r4}$) umfaßt, die in Darlington-Schaltung angeordnet sind, und einer Konstantstromquelle ($T_{r1}$, $T_{r5}$, $R_1$), die gemeinsam mit den ersten und zweiten Umschaltschaltkreisen verbunden ist,
dadurch gekennzeichnet, daß der zweite Stromumschaltschaltkreis ($T_{r3}$, $T_{r4}$) derart aufgebaut ist, daß der gesamte vom Emitter des zweiten Transistors ($T_{r4}$) fließende Strom der Basis des ersten Transistors ($T_{r3}$) zugeführt wird, wobei die Basis des zweiten Transistors ($T_{r4}$) mit einem zweiten Eingangsanschluß (5) verbunden ist, an den ein zum ersten Eingangssignal komplementäres zweites Eingangssignal angelegt wird, wobei dieses Signal eine elektrische Potentialdifferenz erzeugt, die größer ist als die Logik-Schwellenwertspannung des zweiten Umschaltschaltkreises, wobei die Kollektoren der ersten und zweiten Transistoren ($T_{r3}$, $T_{r4}$) gemeinsam mit einem Ausgangsanschluß verbunden sind, und daß die Konstantstromquelle ein Darlington-Transistorenpaar umfaßt, d.h. einen dritten Transistor ($T_{r5}$), dessen Basis eine konstante Spannung ($V_{ref}$) empfängt, und einen vierten Transistor ($T_{r1}$), dessen Basis mit dem Emitter des dritten Transistors ($T_{r5}$) verbunden ist, wobei der Emitter des vierten Transistors ($T_{r1}$) mit einer Spannungsquelle (V) durch einen Widerstand ($R_1$) verbunden ist und die Kollektoren beider Transistoren ($T_{r5}$, $T_{r1}$) gemeinsam miteinander und mit den ersten und zweiten Umschaltschaltkreisen verbunden sind.

2. Differentialumschaltschaltkreis nach Anspruch 1, zusätzlich umfassend eine Mehrzahl von Stu-

fen von Puffer-Transistoren ($T_{r7}$, $T_{r8}$, $T_{r9}$, $T_{r10}$), die in Reihe zwischen die Stromquelle und die ersten und zweiten Umschaltschaltkreise geschaltet sind, und eine Bezugsspannungsquelle zur Aufrechterhaltung einer stabilen Spannung (V) am Widerstandsende der Konstantstromquelle.

3. Differentialumschaltschaltkreis nach Anspruch 1, wobei die ersten und zweiten Stromumschaltschaltkreise n-p-n-Transistoren umfassen.

## Revendications

1. Circuit de commutation différentiel comprenant :
un premier circuit de commutation de courant ($T_{r2}$) constitué d'un étage à un seul transistor qui possède une première borne d'entrée (2) à laquelle est appliqué un premier signal d'entrée, et une première tension de seuil,
un deuxième circuit de commutation de courant ($T_{r3}$, $T_{r4}$) possédant une deuxième tension de seuil différente de ladite première tension de seuil, et comprenant un premier transistor ($T_{r3}$) et un deuxième transistor ($T_{r4}$) disposés en montage Darlington, et
une source de courant constant ($T_{r1}$, $T_{r5}$, $R_1$) connectée en commun auxdits premier et deuxième circuits de commutation,
caractérisé en ce que le deuxième circuit de commutation de courant ($T_{r3}$, $T_{r4}$) est constitué de manière que la totalité du courant sortant de l'émetteur du deuxième transistor ($T_{r4}$) soit fournie à la base du premier transistor ($T_{r3}$), la base du deuxième transistor ($T_{r4}$) étant connectée à une deuxième borne d'entrée (5) à laquelle un deuxième signal d'entrée, complémentaire dudit premier signal d'entrée, est appliqué, ce signal produisant une différence de potentiel électrique qui est supérieure à la tension de seuil logique dudit deuxième circuit de commutation, les collecteurs des premier et deuxième transistors ($T_{r3}$, $T_{r4}$) étant connectés en commun à une borne de sortie,
et en ce que la source de courant constant comprend une paire de transistors Darlington, c'est-à-dire un troisième transistor ($T_{r5}$) dont la base reçoit une tension constante ($V_{ref}$) et un quatrième transistor ($T_{r1}$) dont la base est connectée à l'émetteur du troisième transistor ($T_{r5}$), l'émetteur du quatrième transistor ($T_{r1}$) étant connecté à une source de tension (V) par l'intermédiaire d'une résistance ($R_1$), et les collecteurs des deux transistors ($T_{r5}$, $T_{r1}$) étant connectés en commun ensemble et aux premier et deuxième circuits de commutation.

2. Circuit de commutation différentiel selon la revendication 1, comprenant en outre plusieurs étages de transistors tampons ($T_{r7}$, $T_{r8}$, $T_{r9}$, $T_{r10}$) connectés en série entre la source de courant et les premier et deuxième circuits de commutation, et

une source de tension de référence servant à maintenir une tension stable (V) sur l'extrémité, associée à la résistance, de la source de courant constant.

3. Circuit de commutation différentiel selon la revendication 1, où les premier et deuxième circuits de commutation de courant comprennent des transistors de type n-p-n.

## Fig. 1

## Fig. 2a

## Fig. 2b

# Fig. 3 b          Fig. 3a          Fig. 3c

# Fig. 4a

# Fig. 4b

# Fig. 4 c

# Fig. 4d

Fig. 5